# EUROPEAN PATENT APPLICATION

(11) **EP 4 815 027 A1**
(43) Date of publication of application: **30.09.2026**
(21) Application number: 26163430.7
(22) Date of filing: 10.03.2026
(51) Int. Cl.: H01J 37/32, H05H 1/00, H05H 1/26

(54) **PLASMA OUTPUT MONITORING SYSTEM**

(30) Priority: 24.03.2025 US 202519088238
(71) Applicant: ASMPT Singapore Pte. Ltd., Singapore 768924 (SG)
(72) Inventor: GAN, Zhuofei, Hong Kong (HK); CHENG, Le, Hong Kong (HK); YANG, Lei, Hong Kong (HK); LI, Ming, 768924 Singapore (SG)
(74) Representative: Emerson, Peter James

(57) **Abstract**

In a method for monitoring a plasma output from a plasma device used to clean an object, a first wavelength of light emitted by the plasma output to be monitored is identified and an intensity of the first wavelength of light is sensed. A second wavelength of light emitted by the plasma output is also identified to be used as a baseline, and an intensity of the second wavelength of light is sensed. The intensities of the first and second wavelengths of light are then compared to determine whether their relationship falls within an acceptable threshold.

## Description

### Field of the Invention

The invention relates to the generation of atmospheric plasma during processes for assembling electronic processes, and in particular to the monitoring of plasma output that is generated in order to maintain a quality of the plasma output.

### Background and Prior Art

In the packaging of integrated circuits or dies with fine pitches and large die sizes, impurities such as oxides and organic contaminants are conventionally removed from the dies using flux. However, after the cleaning of such impurities, it is typically challenging to remove flux residue, which is notoriously difficult to get rid of. Flux residue is even more difficult to remove for packages with fine bond pitches and large die sizes. Failure to adequately remove flux residue can lead to significant package reliability issues in the final product after performing die bonding, since residual flux can cause electrical leakage, corrosion, and other failures.

The recent adoption of fluxless processes has significantly broadened the applications of die bonding, especially thermocompression die bonding. These fluxless processes are particularly effective for assembling packages with bump pitches that range from 10 to 40 microns, thereby extending the applicability of die bonding processes for assembling electronic devices, as well as enhancing their overall efficiency and reliability.

More recently, plasma treatment has been applied to remove metal oxides (such as tin oxide and copper oxide) before die bonding, in particular prior to a thermocompression die bonding process. This approach has shown promise in improving the quality of solder joints by providing cleaner surfaces for conducting the bonding of dies. Removing the oxides also enhances bonding reliability by improving wettability.

When conducting plasma cleaning, particularly plasma cleaning using hydrogen plasma treatment, the control of the plasma process is crucial. Inadequate or excessive treatment may lead to deficiencies or defects. Currently, there are no effective methods for accurately monitoring and controlling the plasma process. Such lack of effective control can result in inconsistent treatment outcomes, affecting the yield of the final product that is manufactured.

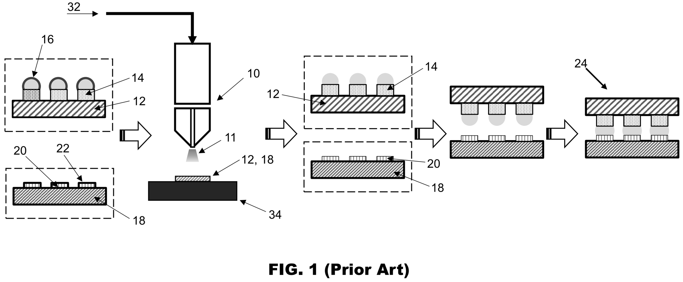

FIG. 1 is a schematic illustration of an exemplary thermocompression bonding process that adopts plasma treatment in the course of the bonding process. A first component such as a first die 12 containing tin-based bumps 14 is to be bonded to a second component such as a second die 18 containing copper-based pad bumps 20. Each of the tin-based bumps 14 initially includes a first native oxide layer 16 on its surface, and each of the copper-based pad bumps 20 initially includes a second native oxide layer 22 on its surface. Such native oxide layers 16, 22 may lead to poor quality of solder joints that are formed during die bonding processes.

Although there are two dies 12, 18 illustrated in this example, in normal usage, other types of components may also be bonded to each other. For instance, the components to be bonded may include dies or wafers, or a combination thereof. The bonding medium or layer may also include one or more of tin, copper, gold, silver, zinc and other suitable bonding materials.

A plasma device 10 may be used to apply plasma treatment for cleaning the said native oxide layers 16, 22 prior to bonding being performed. The plasma device 10 generates plasma onto the respective tin-based bumps 14 and copper-based pad bumps 20 for removing the first and second native oxide layers 16, 22 respectively that are present on their surfaces. After cleaning, the said oxide layers 16, 22 are removed, resulting in tin-based bumps 14 and copper-based pad bumps 20 that are free of the oxide layers. The first die 12 may then be flipped so that the tin-based bumps 14 are facing the copper-based pad bumps 20, and thereafter, the tin-based bumps 14 are bonded onto the copper-based pad bumps 20 using thermocompression die bonding to form a bonded electronic device 24.

It has been found that plasma devices 10 adopted for vacuum-based plasma treatments are not suitable for use in association with thermocompression die bonding due to their large footprint, which makes process integration challenging. Moreover, vacuum-based plasma processes are time-consuming, resulting in low throughput. On the other hand, while conducting plasma treatment under an atmospheric pressure environment, the signal from the plasma is often too weak to be detected accurately because of high noise levels, making it challenging to monitor the quality of the plasma in order to ensure consistent and effective plasma treatment. Thus, when using atmospheric pressure plasma, the plasma treatment performance can presently be characterized only after completing the process, although real-time or in situ plasma monitoring would be necessary for the purpose of improving die bonding process control in industrial use.

It would be beneficial to develop a method of monitoring a quality of the plasma output during the plasma treatment process.

### Summary of the Invention

It is thus an object of the invention to seek to ensure that plasma generated by the plasma device is within acceptable thresholds by monitoring an intensity of one or more gases comprised in the said plasma.

Accordingly, the invention provides a method for monitoring a plasma output from a plasma device used to clean an object, the method comprising: identifying a first wavelength of light emitted by the plasma output to be monitored; sensing an intensity of the first wavelength of light; identifying a second wavelength of light emitted by the plasma output as a baseline; sensing an intensity of the second wavelength of light; comparing the intensities of the first and second wavelengths of light; and determining whether a relationship between the sensed intensities of the first and second wavelengths of light falls within an acceptable threshold.

It would be convenient hereinafter to describe the invention in greater detail by reference to the accompanying drawings which illustrate specific preferred embodiments of the invention. The particularity of the drawings and the related description is not to be understood as superseding the generality of the broad identification of the invention as defined by the claims.

### Brief Description of the Drawings

Specific examples of methods for monitoring a plasma output in accordance with the invention will now be described with reference to the accompanying drawings, in which:
FIG. 1 is a schematic illustration of an exemplary thermocompression bonding process that adopts plasma treatment in the course of the bonding process;
FIG. 2 is a schematic illustration of a plasma device that is movable between a position of a sensor arrangement and a position of a die;
FIG. 3 is a graph showing intensities of light at different wavelengths that are detected from a plasma output;
FIG. 4 is a side view of a plasma output being detected by a sensor arrangement according to a first preferred embodiment of the invention;
FIG. 5 is a side view of an output of a plasma device being detected by a sensor arrangement according to a second preferred embodiment of the invention;
FIG. 6A is a side view of a movable plasma device located over a position of a sensor arrangement, FIG. 6B is a side view of the plasma device located over a position of a die, and FIG. 6C is a side view of the plasma device that has moved back to a position over the sensor arrangement;
FIG. 7A is a side view of a stationary plasma device located over a sensor arrangement, FIG. 7B is a side view of die that has been moved to a position underneath the plasma device, and FIG. 7C is a side view of the die that has moved away from the sensor arrangement; and
FIG. 8 is a graph demonstrating how a filter should be selected so that intensities of light of relevant wavelengths are obtainable for monitoring the plasma output.

### Detailed Description of the Preferred Embodiments of the Invention

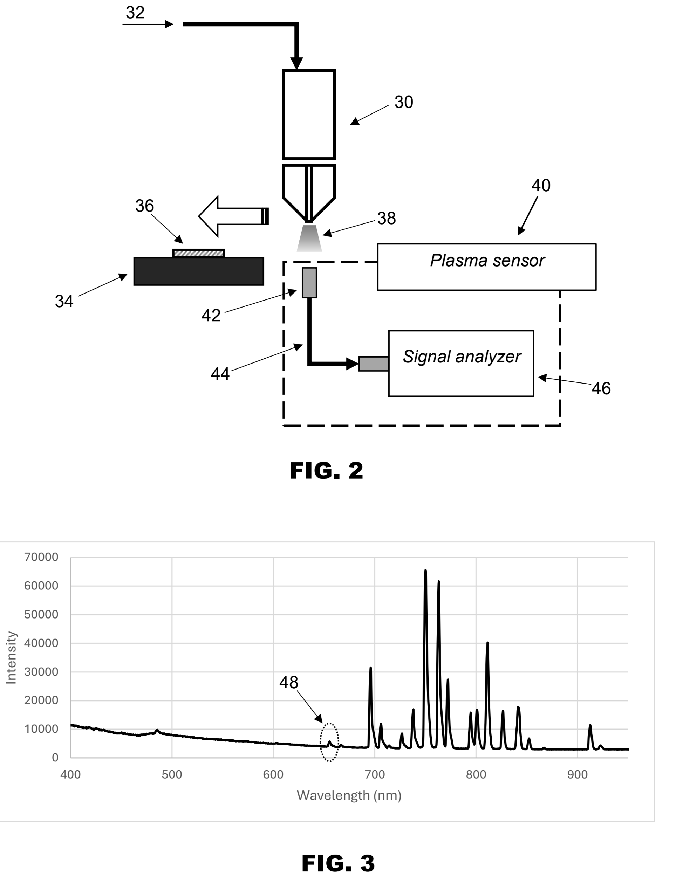

FIG. 2 is a schematic illustration of a plasma device 30 that is movable between a position of a sensor arrangement 40 and a position of a die 36. The plasma device 30 may be an atmospheric pressure plasma jet, which is operable under atmospheric pressure conditions without having to be enclosed within a vacuum environment. The plasma device 30 is typically supplied with a mixture of gases 32, such as a mixture of hydrogen gas and argon gas. An ionized plasma output 38 is generated from a nozzle of the plasma device 30 that is directed downwards for cleaning objects. Such objects may be in the form of dies 36 that are arranged underneath the plasma device 30. Other relevant objects, such as but not limited to wafers or substrates on which the dies 36 are to be bonded, can also be cleaned in this way.

The die 36 to be cleaned before bonding is placed onto a carrier for supporting objects, such as a die carrier 34, which is maintained at a stationary position in this embodiment. The plasma device 30 is movable over the die carrier 34 in order to clean an entire surface of the die 36. The plasma device 30 is also movable to a position over a sensor arrangement 40 which is operative to monitor the plasma output 38 from the plasma device 30.

Light of specific wavelengths are emitted when gas is turned into plasma. In this case, quantification of light emitted from the hydrogen plasma would facilitate plasma stability monitoring. Therefore, the sensor arrangement 40 includes a photodetector 42 integrated with an optical system that converts light into an electrical current, and a cable 44 that connects the photodetector 42 to a signal analyzer 46. Prior to and/or after cleaning a die 36, the plasma device 30 is moved to the position over the sensor arrangement 40 so that the photodetector 42 is able to detect an intensity of light produced by the plasma output 38 generated.

The sensor arrangement 40 may comprise various types of photodetectors such as photodiodes, photomultipliers, spectrometers, or CCD (Charge-Coupled Device) or CMOS (Complementary Metal-Oxide-Semiconductor) sensors. These photodetectors should be further integrated with optical systems, such as lenses and fiber-optics, for enhancing light reception.

FIG. 3 is a graph showing intensities of light at different wavelengths that are detected from a plasma output 38. In this illustration, the intensities of light have been measured using a commercial spectrometer. There are variations in light intensity from the presence of hydrogen and argon gases in the mixture of gases. In particular, while there are prominent light intensity peaks at wavelengths that are about 700nm or longer that are created by the presence of argon gas, there is a relatively smaller prominent intensity peak 48 at the 656.28nm wavelength mark, caused by the presence of hydrogen gas. This prominent emission or intensity peak, known as Hydrogen-alpha (H-α), belongs to the Balmer series and appears in the red part of the visible spectrum. Such a prominent intensity peak 48 at a first wavelength of light that is caused by the presence of hydrogen gas in the gas mixture 32 may be identified and selected as a parameter that is to be monitored in the generated plasma output 38.

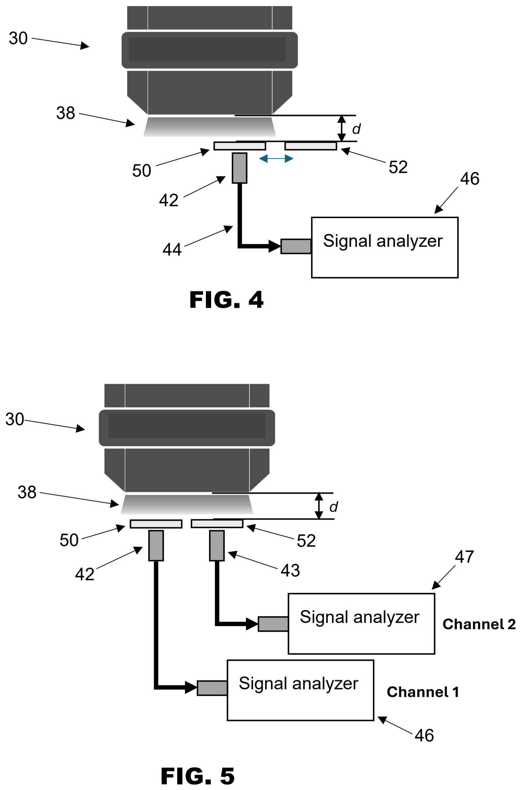

FIG. 4 is a side view of a plasma output 38 being detected by a sensor arrangement 40 according to a first preferred embodiment of the invention. In this first preferred embodiment, the sensor arrangement 40 includes a first filter 50 located between the plasma device 30 and the photodetector 42, wherein the first filter 50 filters out a first range of wavelengths to be received by the photodetector 42, and transmits only the first wavelength of light. The sensor arrangement 40 also includes a second filter 52 located adjacent to the first filter 50 located between the plasma device 30 and the photodetector 42, wherein the second filter 52 filters out a second range of wavelengths to be received by the photodetector 42, and transmits only a second wavelength of light emitted by the plasma output 38 as a baseline.

A distance (d) between the plasma nozzle to the first and second filters 50, 52 would generally depend on the plasma flow rate, nozzle shape and other operational factors. Generally, a distance (d) of between 2-20mm would be suitable. Alternatively, the first and second filters 50, 52 or sensor arrangement 40 may be integrated into the nozzle of the plasma device 30 for monitoring the plasma output 38.

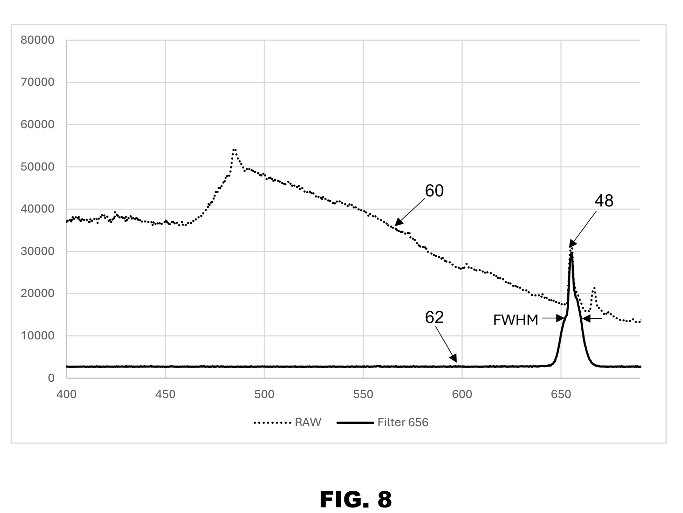

In the scenario illustrated in FIG. 3 where the prominent intensity peak 48 at a wavelength of 656.28nm is being measured, the first filter may be a 650nm filter (which filters out light that have wavelengths other than about 650nm) and the second filter may be a 656nm filter (which filters out light that have wavelengths other than about 656nm). The reason for selecting these filters will be explained in more detail in relation to FIG. 8. If a different wavelength of light is identified and selected to be monitored due to (for instance) a different gas mixture being used, the wavelengths of light that are transmitted by the first and second filters should be adjusted accordingly.

In relation to the use of a 656nm filter, other than Hα peak which has been selected for the above example, it should be appreciated that a suitable filter may also be selected that is applicable to other wavelengths to include other hydrogen plasma prominent intensity peaks such as for Hα, Hβ, Hγ and Hδ. Furthermore, although a specific 656nm filter is being suggested because it is readily available for purchase in the market, other filters that are close to the targeted wavelength, such as a 657 nm filter can also be adopted. As regards the 650 nm filter, it may also comprise other wavelength filters since it merely represents the background or baseline light intensity, and there are many wavelengths that could be adopted to capture the background or baseline light intensity.

When the plasma output 38 is to be monitored, the plasma device 30 is positioned over the photodetector 42. The first and second filters 50, 52 that are adjacent to each other are mounted on a movable platform to enable either the first filter 50 or the second filter 52 is movable to an intermediate location between the plasma device 30 and the photodetector 42, so that the photodetector 42 is able to detect light of either the first wavelength of light or the second wavelength of light respectively.

Plasma monitoring by the sensor arrangement 40 may be performed both before and after plasma treatment. Preferably, a variation detected in the plasma output 38 before and after plasma treatment should be, for instance but not exclusively, less than 1.5% to ensure stable and consistent intensity of plasma generation by the plasma device 30.

FIG. 5 is a side view of an output of a plasma device 30 being detected by a sensor arrangement 40 according to a second preferred embodiment of the invention. In this second preferred embodiment, the photodetector 42 is fixedly mounted with respect to the first filter 50 which is located between the plasma device 30 and the photodetector 42, while a separate photodetector 43 which is connected to a separate signal analyzer 47 is fixedly mounted with respect to the second filter 52 which is located between the plasma device 30 and the separate photodetector 43. Hence, the respective signal analyzers 46, 47 connected to the respective photodetectors 42, 43 may separately analyze the first and second wavelengths of light concurrently. This would be more efficient than analyzing different wavelengths of light filtered by the first and second filters 50, 52 separately at different times in accordance with the first preferred embodiment described in relation to FIG. 4, although the component cost would be higher.

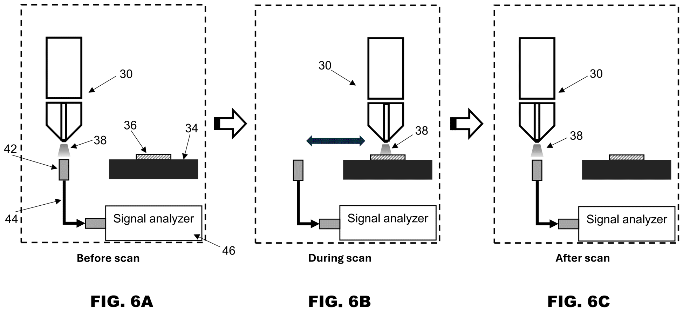

FIG. 6A is a side view of a movable plasma device 30 located over a position of the sensor arrangement 40, where the plasma device 30 is reciprocally movable between a location over the sensor arrangement 40 for monitoring the plasma output 38, and the location over the die carrier 34 for cleaning dies 36. When the plasma device 30 is located over the position of the photodetector 42, the signal analyzer 46 monitors the plasma output 38.

In FIG. 6B, the plasma device 30 is moved to a position over the die carrier 34 where a die 36 has been placed for cleaning. The plasma device 30 may be further movable over the die 36 relative to the die carrier 34 for distributing the plasma output 38 over an entire surface of the die carrier 34, especially if there is a larger surface area where multiple dies 36 have to be cleaned. In FIG. 6C, after cleaning is completed, the plasma device 30 is moved back to a position over the photodetector 42, where the plasma output 38 may again be monitored by the signal analyzer 46.

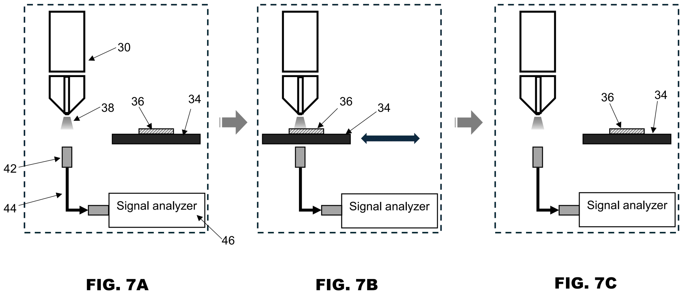

FIG. 7A is a side view of a stationary plasma device 30 that is located over a sensor arrangement 40. In this set-up, neither the plasma device 30 nor the sensor arrangement 40 needs to move. After the plasma output 38 has been monitored by the signal analyzer 46, the die carrier 34 is instead moved from a location remote from the stationary plasma device 30 to a location between the plasma device 30 and the photodetector 42 of the sensor arrangement 40, as shown in FIG. 7B.

When the die carrier 34 is in an intermediate location between the plasma device 30 and the photodetector 42, cleaning of the die 36 that has been placed on the die carrier 34 is conducted. In FIG. 7C, after the cleaning of the die has been completed, the die carrier 34 is moved away from the plasma device 30, so that the plasma output 38 may again be monitored by the signal analyzer 46 of the sensor arrangement 40.

FIG. 8 is a graph demonstrating how the filters 50, 52 should be selected so that intensities of light of relevant wavelengths are obtainable for monitoring the plasma output 38. Illustrated is a first line 60 showing a total raw light intensity output including light at different wavelengths as a reference. Generally, a raw light intensity output at a specific wavelength may be sensed by transmitting light of the specific wavelength. Also illustrated is a second line 62 showing a light intensity output that is sensed when the raw light is filtered by the first filter 50.

As mentioned above, the prominent intensity peak 48 of hydrogen gas or hydrogen plasma occurs at the wavelength of 656.28nm. Where the first filter 50 allows only light with a wavelength of about 656nm to pass through, the said prominent intensity peak 48 of the hydrogen plasma would be detected. Such prominent intensity peak 48 of the hydrogen plasma has a full width at half maximum (FWHM) that is within a narrow band, which is illustrated in FIG. 8 as being between about 653nm and 661nm. In order to compare variations in the prominent intensity peak 48 of hydrogen plasma with the background light intensity arising from argon plasma and other background light as a baseline, the second filter 52 is selected to allow a wavelength of light that is outside the FWHM of the hydrogen plasma to be transmitted. Therefore, a second filter 52 that filters light at a wavelength of 650nm may be selected. Other filters that are higher or lower than 650nm may also be used for representing the background light intensity, as long as the applicable wavelength that is allowed to pass through the filter is outside the FWHM range.

While the absolute value of the H-α peak is not so important, extracting the H-α peak and isolating its effect while excluding the intensity effect from the argon plasma (which is referable to the background or baseline value) would provide very useful information for monitoring the plasma output 38. During the measurement of the prominent intensity peak 48 of the hydrogen gas, the H-α value that is sensed by light allowed through the first filter 50 at about 656nm wavelength is compared to the background or baseline value that is sensed by light allowed through the second filter 52 at about 650nm wavelength. In one embodiment, the comparison may be conducted by monitoring a relationship (*Q*) of the light intensity allowed at the first wavelength of light at 656nm (i.e. a *H-α* peak value filtered by the first filter 50) divided by the light intensity allowed at the second wavelength of light at 650nm (i.e., a baseline value filtered by the second filter 52): *Q = H-α peak value* ÷ *baseline value*

The aforesaid relationship (*Q*) can be used to represent a hydrogen plasma density over time of the plasma output 38.

By monitoring variations in the said hydrogen plasma density over time, variations in a quality of the plasma output 38 is determinable. Therefore, if the hydrogen plasma density is either above or below the acceptable threshold (for example but not exclusively, if a variation in the hydrogen plasma density is greater than 1.5% between measurements), cleaning by the plasma device 30 is temporarily stopped to resolve any issues to prevent inadequate cleaning of subsequent objects such as dies 36, which might cause defects in the quality of the bonded electronic devices 24.

It should be appreciated that the monitoring approach according to the described embodiments of the invention utilizes optical filters and optoelectronics to achieve in situ and real-time monitoring of plasma performance during the removal of metal oxides. This advancement significantly enhances process control when an atmospheric pressure plasma generator is used in association with die bonding equipment, especially thermocompression die bonding equipment.

The approach according to the described embodiments of the invention results in enhanced signal extraction because, unlike for general optical spectroscopy analyses approaches, it focuses on extracting effective signals specifically relevant for the actual gas or gas composition that is being used in the plasma output 38 while suppressing noise. Such a targeted approach ensures more accurate monitoring and control. Moreover, the system enables real-time monitoring within a bonding machine without affecting the bonding throughput. This ensures continuous and efficient operation, while maintaining a high production throughput.

The design of the system is also both cost-effective and compact, which facilitates its integration into complex die bonding machines. Such a design is further compatible with other plasma-based treatments, including vacuum plasma, and can be integrated with various types of bonding processes, such as thermocompression die bonding as well as hybrid bonding.

The stability of the defined relationship between the measured intensity values is capable of reflecting the stability of the metal oxide removal process to enable the in situ and real-time process control for atmospheric plasma operations. The subsequent die bonding process will benefit due to the improved bump-to-bump and bump-to-pad joints in the absence of metal oxides that have been removed.

The invention described herein is susceptible to variations, modifications and/or additions other than those specifically described and it is to be understood that the invention includes all such variations, modifications and/or additions which fall within the spirit and scope of the above description.

## Claims

1. A method for monitoring a plasma output from a plasma device used to clean an object, the method comprising:
identifying a first wavelength of light emitted by the plasma output to be monitored;
sensing an intensity of the first wavelength of light;
identifying a second wavelength of light emitted by the plasma output as a baseline;
sensing an intensity of the second wavelength of light;
comparing the intensities of the first and second wavelengths of light; and
determining whether a relationship between the sensed intensities of the first and second wavelengths of light falls within an acceptable threshold.

2. The method as claimed in claim 1, wherein the intensities of the first and second wavelengths of light are sensed using a sensor arrangement including a photodetector integrated with an optical system.

3. The method as claimed in claim 2, wherein the intensity of the first wavelength of light is sensed by locating the sensor arrangement behind a first filter that transmits the first wavelength of light, and the intensity of second wavelength of light is sensed by locating the sensor arrangement behind a second filter that transmits the second wavelength of light.

4. The method as claimed in claim 3, wherein the plasma device is movable relative to the first and second filters for directing the plasma output towards the first and second filters respectively, to enable the sensor arrangement to separately sense the intensities of the first and second wavelengths of light or the sensor arrangement includes a first photodetector fixedly mounted with respect to the first filter and a second photodetector fixedly mounted with respect to the second filter for concurrently sensing the intensities of the first and second wavelengths of light.

5. The method as claimed in claim 2, wherein the plasma device is reciprocally positionable between a location over the object for cleaning the object and a location over the sensor arrangement for the sensor arrangement to sense the intensities of the first and second wavelengths of light.

6. The method as claimed in claim 6, wherein the plasma device and sensor arrangement remain stationary while a carrier supporting the object is movable such that the carrier is reciprocally movable from a location remote from the stationary plasma device to a location between the stationary plasma device and sensor arrangement.

7. The method as claimed in claim 2, wherein the photodetector is selected from the group consisting of a photodiode, a photomultiplier, a spectrometer, a CCD sensor and a CMOS sensor.

8. The method as claimed in claim 2, wherein the first and second filters are mounted on a movable platform adjacent to each other, to enable either the first filter or the second filter to be positioned to an intermediate location between the plasma device and the photodetector for sensing either the first wavelength or the second wavelength of light, and/or
the plasma output is sensed by the sensor arrangement both before and after the object is cleaned by the plasma device.

9. The method as claimed in claim 1, wherein the first wavelength of light is identified by choosing a wavelength of light corresponding to a prominent intensity peak associated with one or more gases comprised in the plasma output.

10. The method as claimed in claim 9, wherein the prominent intensity peak is caused by hydrogen plasma comprised in the plasma output.

11. The method as claimed in claim 10, further comprising monitoring variations in a density of the hydrogen plasma over time, and wherein the prominent intensity peak corresponds to a hydrogen-alpha emission.

12. The method as claimed in claim 11, wherein the first wavelength of light is selected within a full width at half maximum (FWHM) of the prominent intensity peak, and the second wavelength of light is selected outside the FWHM.

13. The method as claimed in claim 1, wherein monitoring of the plasma output includes isolating an effect of the intensity of the first wavelength of light from an effect of the intensity of the second wavelength of light.

14. The method as claimed in claim 1, further comprising the step of stopping the plasma output to prevent inadequate cleaning of subsequent objects when the relationship between the sensed intensities of the first and second wavelengths of light falls outside the acceptable threshold.

15. The method as claimed in claim 1, wherein the plasma device is an atmospheric pressure plasma jet, and/or the plasma output comprises a mixture of plasma gases, including hydrogen plasma.
